# EUROPEAN PATENT SPECIFICATION

(11) **EP 1 182 695 B1**
(45) Date of publication and mention of the grant of the patent: **21.11.2007**
(21) Application number: 01307107.1
(22) Date of filing: 21.08.2001
(51) Int. Cl.: H01L 21/00, C23C 14/56

(54) **Semiconductor processing module and apparatus**
Halbleiterverarbeitungsmodul und Vorrichtung
Module et dispositif de traitement de semiconducteur

(30) Priority: 22.08.2000 JP 2000251455; 28.06.2001 JP 2001196802
(43) Date of publication of application: 27.02.2002
(73) Proprietor: ASM JAPAN K.K., Tama-shi, Tokyo 206-0025 (JP)
(72) Inventor: Yamagishi, Takayuki, Tama-shi, Tokyo 206-0025 (JP); Suwada, Masaei, Tama-shi, Tokyo 206-0025 (JP); Watanabe, Takeshi, Tama-shi, Tokyo 206-0025 (JP)
(74) Representative: Mallalieu, Catherine Louise

(56) References cited:
- EP-A- 0 180 373
- WO-A-99/18603

## Description

### Field of the Invention

The present invention relates to a semiconductor-manufacturing apparatus using a vacuum load lock chamber connected to a reactor, and it particularly relates to a semiconductor-manufacturing apparatus comprising compact free-layout single-wafer-processing units, its gas-line system, and the structure of a reactor.

### Description of the Related Art

Generally, chambers of a semiconductor-manufacturing apparatus using a vacuum load lock system comprise a load lock chamber, a transfer chamber and multiple reactors (processing chambers) connected with the transfer chamber. For each chamber, a substrate-handling robot for automatically supplying substrates is used and it functions as described in the following: First, the atmospheric robot brings a substrate inside a load lock chamber from a cassette or a front opening unified pod ("FOUP", e.g., a detachable cassette and a box with a front-opening interface). After evacuating air into the load lock chamber, the substrate is transferred to each reactor by a vacuum robot provided inside a common polygon-shaped transfer chamber. The substrate processed in the reactor is transferred inside the load lock chamber by the vacuum robot. Lastly, after restoring atmospheric pressure inside the load lock chamber, the processed substrate is taken out to the cassette or the FOUP by the atmospheric robot. This type of apparatus is generally called a cluster tool.

Conventionally, there are two types of cluster tools, i.e., a single-wafer-processing type and a batch-based wafer processing type. With the single wafer processing type, each reactor processes one wafer at a time. With the batch-based wafer processing type, a single reactor processes multiple wafers at a time.

Because the batch-based wafer processing apparatus processes multiple sheets of substrates in a single reactor, its productivity is high. A thin film formed on a substrate by the batch-based wafer processing apparatus, however, is not uniform in thickness and quality and this often becomes a problem. To improve the uniformity of film thickness and quality, using a single-wafer-processing apparatus is effective.

If attempting to increase productivity using a conventional single-wafer-processing type apparatus, the number of reactors increases, the footprint (an area occupied by an apparatus) and faceprint (the width of an apparatus front panel) increase, and costs increase as well. This is because the conventional single-wafer-processing apparatus possesses a common polygon shaped transfer chamber and reactors are attached to it, radiating in all directions. Additionally due to the number of sides of a polygon, the number of reactors or a layout is restricted. Furthermore, conventionally, each reactor independently possesses a gas line and a vacuum line, and independently performs deposition (film forming). If increasing the number of reactors to improve productivity, the number of vacuum elements increases because the same number of gas lines and vacuum pumps as the reactors is required. As a result, costs per reactor increase and at the same time the footprint increases.

Furthermore, in conventional single-wafer-processing semiconductor-manufacturing apparatus, a reactor has a one-layered structure, and placing and processing a substrate are performed inside the same chamber. Consequently, the capacity of a processing chamber is large, and an amount of reaction gas and time required for deposition and cleaning increase accordingly. To solve this problem, a method for reducing the capacity of a processing chamber by sealing a reactor after a wafer is transferred was reported (United States Patent No. 5,730,801 or Japanese Patent Laid-open No. 8-172037). This method is a technique generally used for batch-processing vertical furnaces. If applying this method to single-wafer-processing reactors, the following problem occurs: Normally, for a susceptor inside a single-wafer-processing reactor, to create a space between a substrate and a susceptor so that end factors of a vacuum robot can get in and out when transferring a substrate, a substrate lift pin passing through the susceptor is provided for supporting a substrate temporarily. To perform sealing at the periphery of a susceptor, it is necessary to fill this through hole. For sealing up the hole, one approach using a substrate lift pin's own weight for this purpose was devised. It provides the lift pin with a flange which can seal the hole (United States Patent No. 5,730,801 or Japanese Patent Laid-open No. 8-172037). This approach, however, is very unstable and has a risk wherein a leak may occur when sealing is not done properly, for example, if the pin is caught under some influence or if pressure inside a transfer chamber becomes higher than pressure inside a processing chamber.

Additionally, Japanese Patent Laid-open No. 10-30183 discloses an ashing apparatus including a transfer mechanism inside a load lock chamber connected to a processing chamber, which is characterized simply in that a handing unit holding a semiconductor substrate is loaded and unloaded to and from the processing chamber. According to the above structures, the footprint or faceprint can be reduced to a certain degree. However, a reduction of the footprint or faceprint is not satisfactory, and no consideration is given to improve process efficiency and productivity or to simplify a total system or scale-up apparatus. The above structure will be explained further later.

Further, Japanese Patent Laid-open No. 10-154739 (or U.S. patent No. 5,855,681) discloses a substrate-processing apparatus comprising (a) a load lock chamber, (b) a transfer chamber, (c) more than one reactors, each being connected to the transfer chamber and having multiple (virtually two) processing zones, and (d) a first substrate-handling member provided inside the transfer chamber. This apparatus includes multiple reactors but must include the transfer chamber as a platform common to the reactors in addition to the load lock chamber. A reduction of the footprint or faceprint cannot be achieved, and insufficient consideration is given to improve process efficiency and productivity or to simplify a total system or scale-up apparatus. The above structure will be explained further later.

WO-A-99/18603 describes an apparatus for performing a process on a substrate, comprising:
a conveyor to support the substrate along a work flow path;
a substrate transfer mechanism configured and arranged to remove the substrate from and place another substrate on said conveyor; and
at least one processing island located along said flow path, each processing island having a valve for introduction and extraction of the substrate into and out of an interior thereof.

EP-A-0 180 373 describes a plasma reactor for the manufacturing of semiconductor devices having powered loadlocks and a main process chamber where slices can be processed one slice at a time with pre-etch plasma treatments before the main etching processing and afterwards receive a post etch treatment. The system comprises powered loadlocks, a main chamber, vacuum pumps, radio frequency power supplier, radio frequency matching networks, heat exchangers and throttle valve and pressure controllers, gas flow distribution and microprocessor controllers. The semiconductor wafers are automatically fed one at a time from storage cassettes through isolation gates with articulated mechanical arms to a powered entry loadlock for pre-etching processes. At the completion of the pre-etching processing, the semiconductor wafer is transferred to the main chamber automatically for the main etch process and then to the powered exit loadlock for post etch treatment and finally to an output cassette.

### Summary of the Invention

Consequently, an aim of the present invention is to provide a semiconductor-manufacturing apparatus that realizes low costs, a small footprint and a small faceprint.

Another aim of the present invention is to provide a compact and free-layout semiconductor-manufacturing apparatus that can accommodate a range from small-quantity production to mass production.

Still another aim of the present invention is to provide a semiconductor-manufacturing apparatus that realizes a stable process and high throughput.

Yet another aim of the present invention is to provide a gas-line system which includes a gas line and a vacuum line, realizing labor reduction and low costs.

Further another aim of the present invention is to provide a sealing mechanism for a reactor, which can securely seal a reaction zone of a processing chamber for treatment, which zone is defined by dividing the interior of the processing chamber using a simple structure or another structure that can obtain the same effects as obtained using a seal.

The above aims are merely examples and do not limit the scope of the present invention. To achieve the above-mentioned aims, the present invention includes the following embodiments:

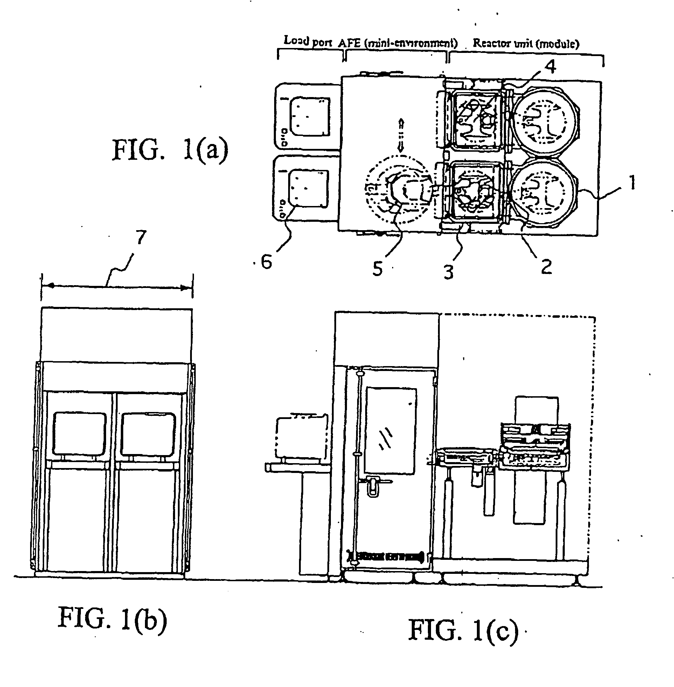

According to the present invention there is provided a semiconductor processing module adapted to be connected to an atmospheric robot unit, comprising;
(a) multiple single-wafer processing units disposed side by side, each unit comprising:
   a reactor for treating a semiconductor substrate, said reactor having a pressure control valve in a gas exhaust line; and
   at least one load lock chamber for transferring the semiconductor substrate into and from the reactor in a vacuum, said load lock chamber having a front end and a rear end, said rear end being connected immediately to said reactor via a gate valve, said front end being adapted to be connected to the atmospheric robot unit via a flapper valve, said load lock chamber comprising a vacuum robot having linked arms with one revolving shaft for transferring the semiconductor substrate into and from said reactor by straight movement through the gate valve; and
(b) a gas supply system common to said multiple units, wherein gas flow of each reactor is controlled by the pressure control valve provided in each reactor. Figures 1(a)-1(c), 2(a)-2(d), 6, 7, and 11, for example, show embodiments of this aspect.

In the above, the pressure control valve may be an auto pressure control (APC) adjustable butterfly valve.

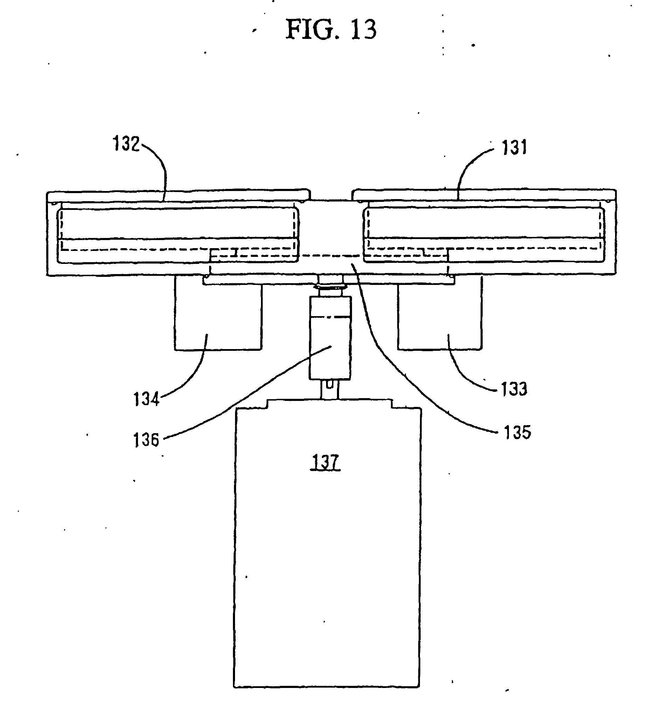

In an embodiment, the load lock chambers may communicate with each other through a manifold connecting a lower portion of each load lock chamber, whereby vacuum operation is controlled as one load lock chamber. Figure 13, for example, shows this embodiment.

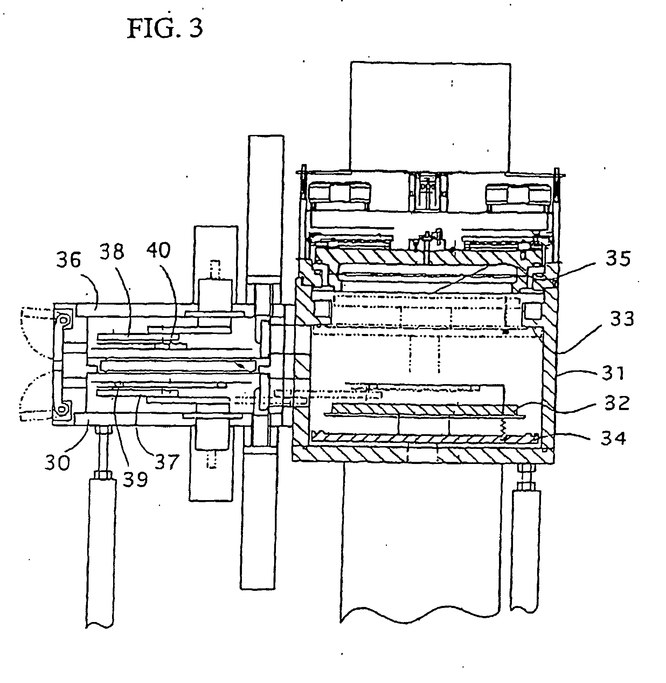

In another embodiment, each unit can have two load lock chambers, wherein one chamber is placed on top of the other chamber, and one of the chambers transfers the semiconductor substrate into the reactor in a vacuum, whereas the other chamber transfers the semiconductor substrate from the reactor in a vacuum. Figure 3, for example, shows this embodiment.

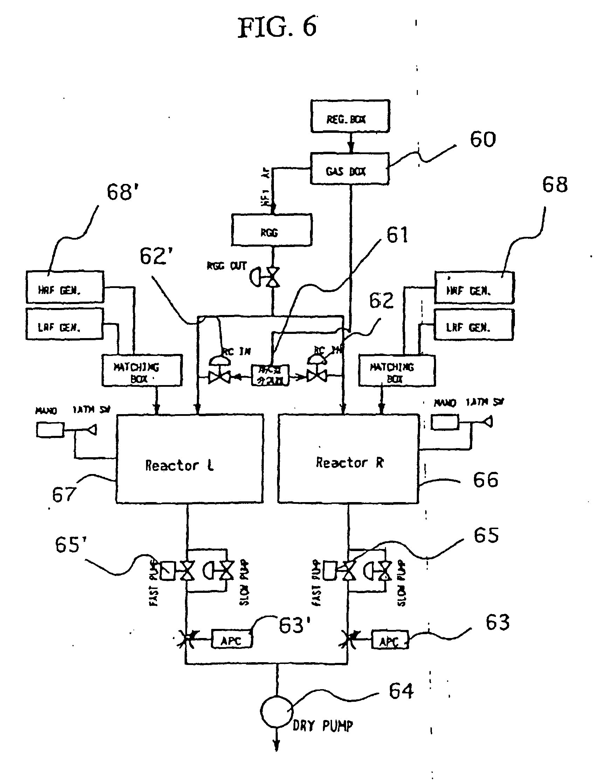

Regarding the gas supply system of the module, the gas supply system may be provided with a flow divider for supplying gas equally to each reactor, and further comprise a gas stop valve for each reactor between said flow divider and each reactor. The gas supply system may also be provided with a mass flow controller for each reactor. Regarding the gas exhaust system, the module may comprise a vacuum exhaust valve for each reactor between the pressure control valve and the reactor. The gas exhaust system may be common to the respective reactors, i.e., a single gas exhaust system. Figures 6, 7, and 11, for example, show these embodiments.

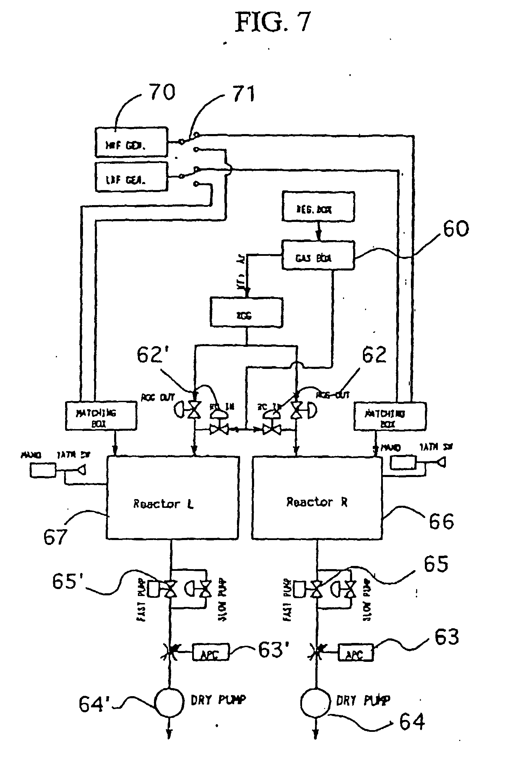

In an embodiment, the module may further comprise one RF generator and a switch for electrically connecting said RF generator and one of the reactors, wherein deposition and cleaning are alternately performed in the respective reactors. Figure 7, for example, shows this embodiment.

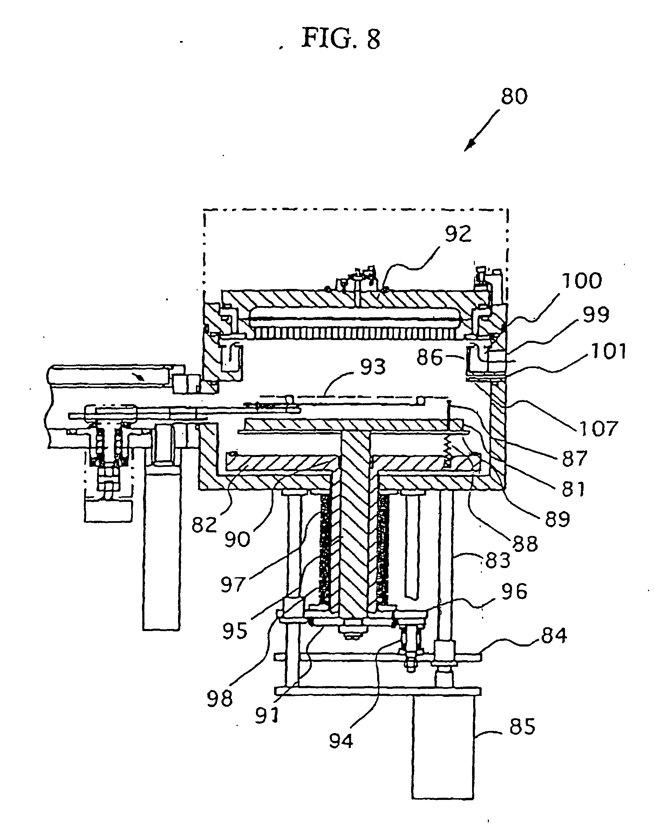

Regarding the reactor, in an embodiment, it comprises: (a) a susceptor for placing a semiconductor substrate thereon; (b) a seal plate provided below and coaxially with said susceptor, said seal plate having a larger diameter than the susceptor and a seal surface along its periphery; (c) an elevating/descending device for moving said susceptor and said seal in a vertical direction; (d) a showerhead provided on a ceiling of said reactor for introducing gas; and (e) a duct member provided near said showerhead and having a circular projection formed along an inner wall of said reactor, wherein: (i) at a position where the susceptor and the seal plate elevate and the seal surface of the seal plate contacts the circular projection of the duct member, the interior of the reactor is divided by the seal plate into an upper reaction compartment and a lower compartment, in which reaction compartment a substrate on the susceptor is treated; and (ii) at a position where the susceptor and the seal plate descend, a substrate is transferred via the gate valve. Figures 8-10, for example, shows this embodiment.

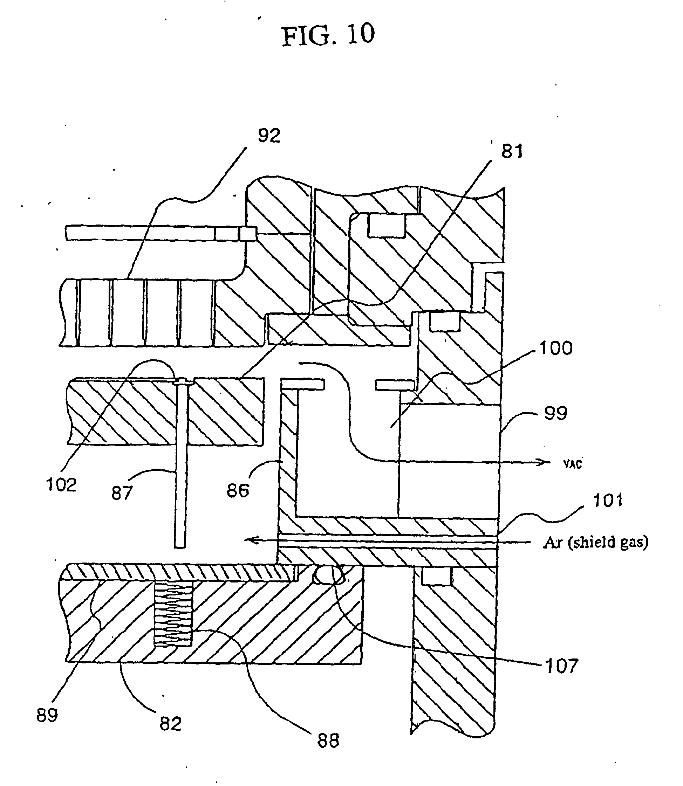

In the above, the reactor may further comprise: (f) at least three substrate lift pins passing through said susceptor for supporting a substrate over said susceptor; (g) a disk for supporting said substrate lift pins, which is provided between the susceptor and the seal plate and coaxially with said susceptor, said disk having a diameter smaller than the seal plate but larger than the inner diameter of the circular projection; and (h) a floating elastic material having an upper end supporting said disk from its back and a lower end inserted in a recess formed in said seal plate, wherein when said seal plate Is sealed to said circular projection of the duct member, said disk is also held by the circular projection to push said floating elastic material back in the recess of the seal plate, and said substrate lift pins descend to a position where the tip of each substrate lift pin is at a level the same as or lower than a susceptor surface. Further, the seal plate may be provided with a pressing elastic material for securing the seal between the seal surface of the seal plate and the circular projection (see Figure 10, for example).

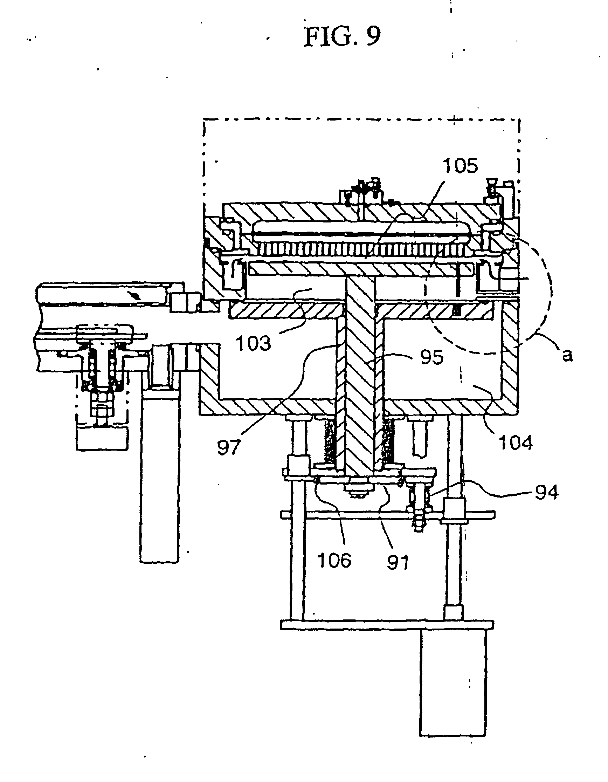

Additionally, the module may further comprises a susceptor height adjusting plate for adjusting the distance between the susceptor and the seal plate, thereby adjusting the distance between the showerhead and the susceptor when the susceptor and the seal plate elevate and the seal plate seals the circular projection of the duct. The susceptor height adjusting plate is installed along and coaxially with a susceptor shaft (see Figures 8 and 9, for example).

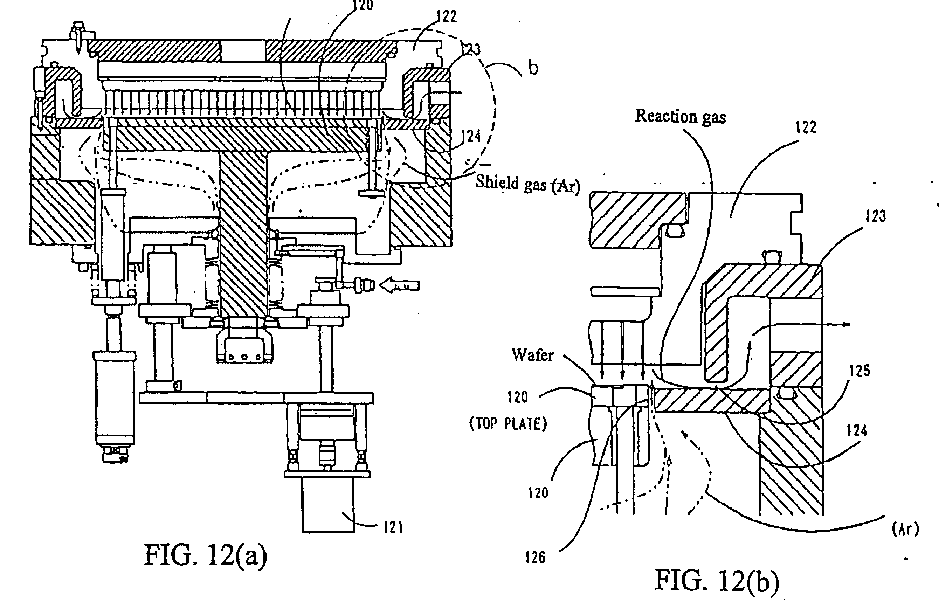

In another embodiment, the reactor may comprise: (a) a susceptor for placing a semiconductor substrate thereon; (b) an elevating/descending device for moving said susceptor in a vertical direction; (c) a showerhead provided on a ceiling of said reactor for introducing gas; (d) a duct member provided near said showerhead and formed along an inner wall of said reactor; and (e) a circular baffle plate provided on the inner wall of said reactor immediately below the duct member, wherein a gap is formed between the circular baffle plate and the duct member, said circular baffle plate having an inner diameter slightly smaller than the susceptor, wherein: (i) at a position where the susceptor elevates and is leveled with the circular baffle plate, the interior of the reactor is divided into an upper reaction compartment and a lower compartment, in which reaction compartment a substrate on the susceptor is treated, wherein an exhaust gas is discharged from the upper reaction compartment through the gap formed between the circular baffle plate and the duct member, and a shield gas is provided into the reaction compartment from the lower compartment through a gap formed between the susceptor and the circular baffle plate; and (ii) at a position where the susceptor descends, a substrate is transferred via the gate valve. Figures 12(a) and 12(b), for example, show this embodiment. In the above, the duct member and the baffle plate may be made of an insulation material.

In another aspect, the present invention provides a semiconductor processing apparatus comprising at least one module described above, and an atmospheric robot unit including an atmospheric robot for transferring a substrate into and from each reactor. See Figures 1(a)-1(c), 4, and 5, for example.

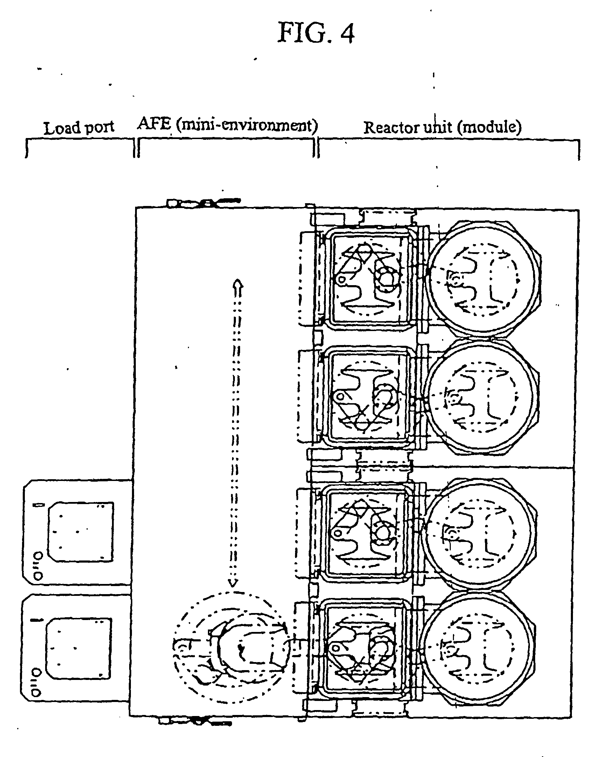

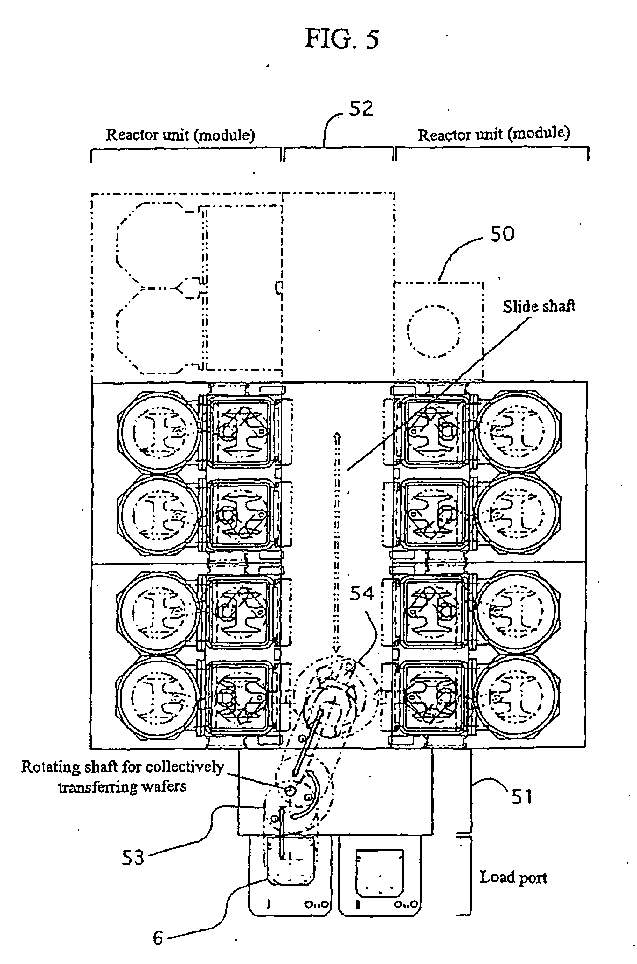

In the above, the atmospheric robot unit may have a sliding shaft in parallel to the load lock chambers, on which shaft the atmospheric robot slides to position in front of each load lock chamber. See Figures 4 and 5, for example. In the above, the multiple modules may be aligned side by side in a line (Figure 4, for example), or the multiple modules may be disposed facing each other via a common atmospheric robot unit comprising an atmospheric robot for transferring a substrate into and from each load lock chamber (Figure 5, for example).

In an embodiment, the apparatus may further comprise an atmospheric transport unit which is connected to the atmospheric robot unit and a loading port, wherein the atmospheric transport unit transfers a substrate or substrates between the atmospheric robot and the loading port. See Figure 5, for example. In the above, the apparatus may include the loading port comprising a cassette and/or an inspection unit. Further, in an embodiment, the atmospheric transport unit may comprise: (a) a slot and an arm shaft for collectively transferring multiple substrates; (b) an elevating/descending shaft; and (c) a rotating shaft for transferring substrates between the loading port and the atmospheric robot, wherein said atmospheric transport unit collectively moves multiple substrates to a position where a substrate is transferred between the atmospheric transport unit and the atmospheric robot while the atmospheric robot does not slide on the sliding shaft.

In the present invention, various combinations of the elements described above can be adopted, and the present invention includes such various combinations.

For purposes of summarizing the invention and the advantages achieved over the prior art, certain objects and advantages of the invention have been described above. Of course, it is to be understood that not necessarily all such aims or advantages may be achieved in accordance with any particular embodiment of the invention. Thus, for example, those skilled in the art will recognize that the invention may be embodied or carried out in a manner that achieves or optimizes one advantage or group of advantages as taught herein without necessarily achieving other aims or advantages as may be taught or suggested herein.

Further aspects, features and advantages of this invention will become apparent from the detailed description of the preferred embodiments which follow.

### Brief Description of the Drawings

These and other features of this invention will now be described with reference to the drawings of preferred embodiments which are intended to illustrate and not to limit the invention.
FIG. 1(a) shows a ground plan of a semiconductor-manufacturing apparatus according to the present invention. FIG. 1(b) shows the front view and FIG.1(c) shows the side view.
FIG. 2(a) to (d) show the operation sequence of a semiconductor-manufacturing apparatus according to the present invention.
FIG. 3 shows a partial cross section of an embodiment in which load lock chambers shown in FIG. 1 are stacked in a vertical direction, forming a two-layer structure.
FIG. 4 shows a plane view of an embodiment in which two of the modules shown in FIG. 1 are linearly arranged in a horizontal direction.
FIG. 5 shows a plane view of an embodiment in which linearly arranged modules are arranged facing each other.
FIG. 6 shows an embodiment of a gas.line system used for a semiconductor-manufacturing apparatus which performs deposition simultaneously in two reactors.
FIG. 7 shows an embodiment of a gas-line system used for a semiconductor-manufacturing apparatus, which alternately performs deposition and cleaning in two reactors.
FIG. 8 is a schematic cross section of a reactor unit according to the present invention, depicting t a semiconductor substrate being transferred.
FIG. 9 is a schematic cross section of a reactor unit according to the present invention, depicting a semiconductor substrate being processed.
FIG. 10 is an enlarged view of the area a shown in FIG. 9.
FIG. 11(a) shows another gas-line system according to the present invention. FIG. 11(b) shows a gas supply system for the reactor provided in a gas box 111 in FIG. 11(a).
FIG. 12(a) is a cross section of another reactor unit according to the present invention. FIG. 12(b) is an enlarged view of the area b shown in FIG. 12(a).
FIG. 13 shows a partial cross section of another embodiment of a semiconductor-manufacturing apparatus according to the present invention.
FIG. 14 shows an atmospheric robot which transfers wafers between a cassette or a FOUP (front opening unified pod) and another atmospheric robot for loading/unloading wafers in/from a reactor.

Major symbols used in the figures are as follows: 1: Reactor; 2: Gate valve; 3: Load lock chamber; 4: Substrate transfer mechanism; 5: Atmospheric robot; 20: Semiconductor substrate; 21: Flapper valve; 22: Susceptor; 23': Substrate support pin

### Detailed Description of the Preferred Embodiment

The present invention is described below in detail referring to figures. FIG. 1 shows a compact single-wafer-processing semiconductor-manufacturing apparatus for forming a thin film on a semiconductor substrate according to the present invention. FIG. 1(a) shows the apparatus in ground plan, FIG. 1(b) shows it in a front view, and FIG.(c) shows it in a side view. The semiconductor-manufacturing apparatus comprises a modularized reactor unit which is describer later, an AFE (atmospheric front end) unit (A portion includes an atmospheric robot for bringing in and taking dut a substrate inside a cassette or FOUP (front opening unified pod) 6 into a load lock chamber), and a load port unit in which the cassette or FOUP 6 is provided. The modularized reactor unit comprises two units by adjacently connecting them. Each unit comprises a reactor 1 for growing a film on a semiconductor substrate, a load lock chamber 3 for having the semiconductor substrate wait in a vacuum, which load lock chamber is directly connected to the reactor via a gate valve 2 and a substrate transfer mechanism provided inside the load lock chamber 3, which has one thin link arm shaft for transferring a semiconductor substrate inside the reactor and which moves a semiconductor substrate in a straight-line direction. In this embodiment, the load lock chamber 3 is one-layered in a vertical direction.

For link methods for an arm, there are several methods including a method having a wire or a timing belt built in the arm, a pantograph method, and a method having a guide installed externally for moving the arm in a straight line. The method having a wire or a timing belt built in the arm can reduce the size of arm in relation to the surface area of a semiconductor substrate. The pantograph method or the method having a guide installed externally has a large surface area, but is able to reduce the thickness of an arm.

For example, the above-mentioned built-in method comprises the first link, one end of which is rotatably and movably attached to a rotating shaft, the second link rotatably and movably attached to the other end of the first link with a pin, and a blade for placing a semiconductor substrate, which blade is rotatably and movably attached to the other end of the second link with a pin. Each pin and the rotating shaft are linked by a wire or a timing belt. The blade moves in a straight-line direction only by the rotation of the rotating shaft. The arm shaft, in which the blade moves in a straight line only by the rotating shaft, is called "one arm shaft".

By using a link arm in a substrate transfer mechanism 4, it is possible to accommodate the arm in a very compact manner. By reducing the thickness of the arm, dead space is further reduced. A link type robot is available from JEL Corporation, Hirosima, Japan (http://www.jel-robot.co.jp), such as #DVA170-01.

FIG. 13 shows a partial side view of another embodiment of a semiconductor-manufacturing apparatus according to the present invention. A portion With a dotted line shows a vacuum zone inside a chamber. As shown in FIG. 13, in this embodiment, two load lock chambers 131 and 132 appear to be adjacent, but each load lock chamber (131 and 132) are communicatively connected through a manifold 135 provided below the chambers, forming virtually one load lock chamber. Below the load lock chambers 131 and 132, rotary actuators 133 and 134 for driving each substrate transfer mechanism are provided. The manifold 135 is linked to a dry pump 137 through a vacuum exhaust valve 136 and piping, Thus, one load lock chamber is exhausted by one exhaust line.

By the embodiments described above, a small capacity of less than 101 can be realized even in the case of a load lock chamber accommodating a substrate with a diameter of 300mm. As a result, it became possible to shorten the time required for vacuuming and restoring atmospheric pressure. Furthermore, by modularizing a reactor unit, it became possible to minimize dead space inside the reactor unit, reducing the faceprint 7 of the entire apparatus.

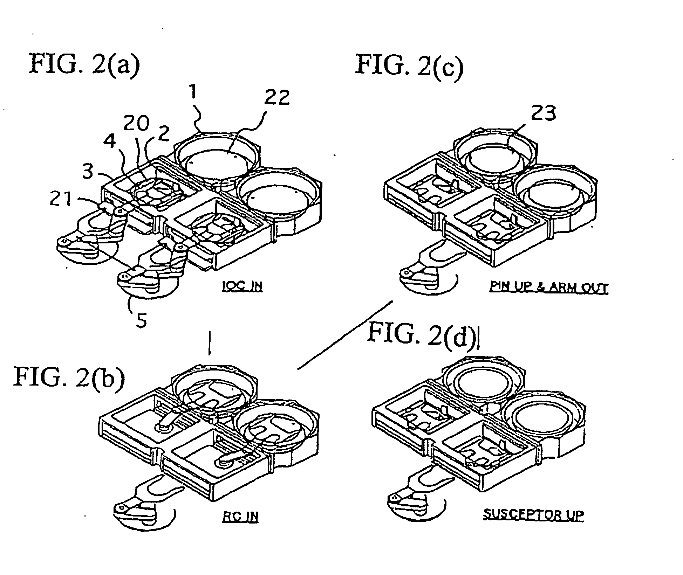

The operation of a semiconductor-manufacturing apparatus according to the present invention is described in the following: Figures 2 (a) to (d) show an operation sequence of the apparatus. In FIG. 2, an atmospheric robot 5 brings a semiconductor substrate 20 inside each load lock chamber 3 from a cassette or an FOUP via a flapper valve 21. After bringing in the semiconductor substrate is has been brought in, the flapper valve 21 is closed and air inside the load lock chamber 3 is evacuated. In FIG. 2(b), a gate valve 2 is opened, and the semiconductor substrate is transferred onto a susceptor 22 inside a reactor 1 by a substrate transfer mechanism 4 having a thin-link type of arm. Because the substrate transfer mechanism 4 comprising the link arm only moves back and forth in a straight line between the load lock chamber and the reactor, adjustment by mechanical positioning is sufficient, eliminating complicate setting. In FIG. 2(c), a substrate support pin 23 protrudes from the susceptor surface, supporting the semiconductor substrate 20. The arm of the substrate transfer mechanism 4 is taken inside the load lock chamber and the gate valve 2 is closed. In FIG. 2(d), the susceptor 22 rises and the semiconductor substrate 20 is placed on the surface of the susceptor 22. Deposition on the semiconductor substrate 20, subsequently starts. After deposition is complete, by following the operation sequence conversely in the order of FIG. 2(d) → (c) → (b) → (a), the processed semiconductor substrate is transferred to the cassette or the FOUP.

According to another embodiment according to the present invention shown in FIG. 13, because both load lock chambers are communicatively connected, they can be simultaneously evacuated and can transfer semiconductor wafers inside the reactors on the same timing. Consequently, two semiconductor wafers are simultaneously processed.

According to the present invention, because multiple substrates can be transferred simultaneously and at the same time deposition can be performed even using a single-wafer-processing system, throughput is high and a process is stable.

Embodiments of a semiconductor-manufacturing apparatus according to the present invention is described in the following: FIG. 3 shows a multiple-layered semiconductor-manufacturing apparatus in which two load lock chambers are placed one upon another vertically. As shown in FIG. 3, the apparatus comprises two levels of opposed load lock chambers 30 and 36, and one reactor 31 connected with the two-level load lock chambers 30 and 36. Inside each load lock chamber (30 and 36), substrate transfer mechanisms 37 and 38 are provided respectively. The lower substrate transfer mechanism 37 comprises a blade to which a pin 39 for placing a thin link arm and a substrate on, or guiding a thin link arm and a substrate, is attached. The lower substrate transfer mechanism supports a semiconductor substrate from the bottom after the substrate is placed on the pin 39 attached to the blade. Different from the lower one, the upper substrate transfer mechanism 38 has a blade and a presser foot stitch tongue 40 for supporting the semiconductor substrate from the top. In this embodiment, as described in detail below, the reactor 31 possesses a seal plate 34 for forming a narrow reaction zone 35 by contacting a seal surface 33 and a susceptor mechanism 32 capable of moving in a vertical direction.

Because this embodiment can process more substrates without increasing the faceprint and the footprint, throughput improves. Because each two-level load lock chamber independently possesses a substrate transfer mechanism, when one load lock chamber is being used, a semiconductor substrate is always in a waiting state inside the other load lock chamber. Consequently, the reactor can perform continuous processing without being restricted by substrate transfer time.

FIG. 4 shows another embodiment of a semiconductor-manufacturing apparatus according to the present invention. As shown in FIG. 4, the apparatus comprises two modules connected linearly in a horizontal direction. An AFE is common to two modules. Any number of modules greater than two can be connected.

Because this embodiment can process many substrates at a time, throughput improves. With no restriction placed on the number of modules per apparatus, it can accommodate any scale of production from a small quantity to mass production. Particularly an embodiment having a low number of modules is effective because an increase in the faceprint is low.

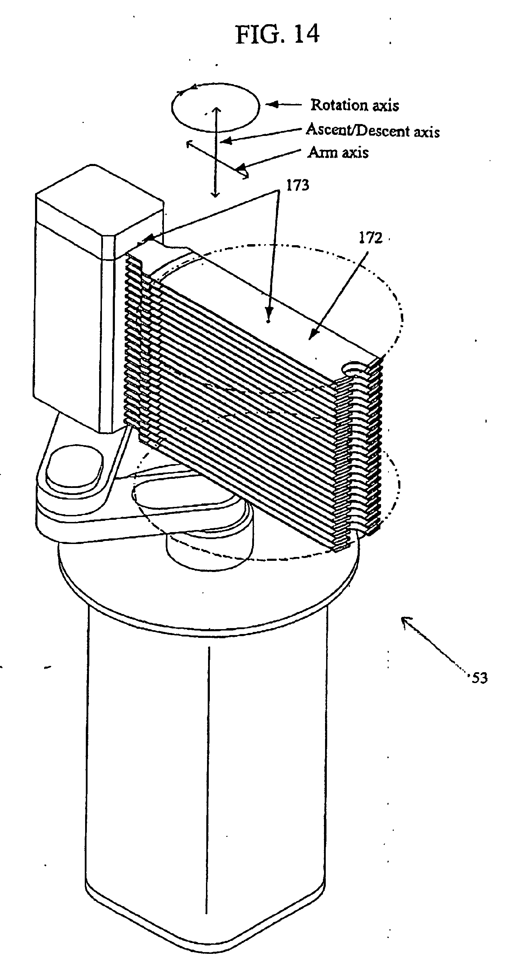

FIG. 5 shows another embodiment of a semiconductor-manufacturing apparatus. In this embodiment, two modules linearly connected in a horizontal direction are placed facing each other. An AFE is common to the four modules. Any number of modules more than two can be connected. In this embodiment, regardless of the number of modules connected, the faceprint is fixed. Additionally, an inspection device 50 for inspecting processed semiconductor substrates can also be connected. With this feature, an inspection process can be included between semiconductor substrate processes. In the apparatus shown in FIG. 5, an AFE comprises a first AFE unit 51 connected to a cassette or an FOUP and a second AFE unit 52 connected to each module. Inside the first AFE unit 51, the first atmospheric robot 53 with an arm shaft, an elevating shaft and rotating shaft, which comprises 25 substrate slots and a link arm, is provided. As shown in FIG. 14, this first atmospheric robot 53 collectively takes 25 substrates inside substrate slots 172 from the cassette or the FOUP 6 holding 25, sheets of substrates, and rotates around the rotating axis until it reaches a position from which it can deliver the substrates to the second atmospheric robot inside the second AFE unit 52. A sensor or sensors 173 are installed at each substrate slot, and configuration information of a substrate inside the cassette or the FOUP 6 ("mapping") is obtained. Inside the first AFE unit, multiple first atmospheric robots 53 can be arranged. The second atmospheric robot 54 can receive or deliver substrates from or to the first atmospheric robot 53 without a slide shaft.

The embodiment shown in FIG. 5 maintains the fixed faceprint and constitutes a free-layout module, enabling many substrates to be processed at a time and; improving throughput. Because the first atmospheric robot does not possess a slide shaft, apparatus space and costs can be curbed. Additionally, due to sensors attached to substrate slots, mapping becomes easier and transfer time can be reduced. Furthermore, the first atmospheric robot can be used as a cooling stage for cooling a substrate heated by a reactor.

A gas-line system of the semiconductor-manufacturing apparatus according to the present invention is described in the following: FIG. 6 shows a preferred embodiment of a gas-line system for reactors in a module according to the present invention. In the module according to the present invention, because deposition can be performed simultaneously on two semiconductor substrates, preferably it is desirable to provide one gas line and one exhaust line for two reactors. A gas line for reactors shown in FIG. 6 comprises one gas line which includes a gas source 60, a flow divider 61 connected with the gas source 60 for equally distributing source gas to two reactors after mixing the source gas supplied from the gas source 60, and gas stop valves 62 and 62' respectively connected between the flow divider 61 and each reactor (66 and 67), and one exhaust line which includes an exhaust pump 64, APCs (auto pressure control adjustable butterfly valves) (63 and 63') connected with the exhaust pump 64 and provided for each reactor (66 and 67), and vacuum exhaust valves 65 and 65' respectively connected between an APC and each reactor (66 and 67). The flow divider 61 has capability to output a gas flow of 0 to 10SLM inputted to the primary side in equal amounts of 0 to 5SLM to the secondary side. APC valves or exhaust throttle valves are available from MKS JAPAN, INC., Tokyo, Japan, such as #252E or #153F.

The operation of the embodiment shown in FIG. 6 is described in the following: Vacuum exhaust valves 65 and 65' are opened, air inside reactors 66 and 67 is evacuated by a vacuum pump 64 and semiconductor substrates are loaded. Gas stop valves 62 and 62' open and source gas is brought inside the reactors. At this time, with a combination of the flow divider 61 and APCs 63 and 63', an equal amount of source gas is respectively brought inside each reactor (66 and 67). High-frequency voltage is applied to semiconductor substrates inside the reactors by RF generators 68 and 68', producing a film-forming reaction inside both reactors.

In the embodiment shown in FIG. 6, pressure is controlled by an APC for each reactor and gas inside each reactor is discharged using a single pump. By using this independent pressure control and the above-mentioned flow divider, deposition can be independently controlled in the same manner as using one gas line per reactor and an individual difference between processing chambers can be coped with. Additionally, because each reactor possesses a gas stop valve and a vacuum exhaust valve, processing can be performed using only one reactor. Furthermore, because a gas-line system comprises one gas line and one exhaust line for two reactors, labor reduction and lower costs can be achieved.

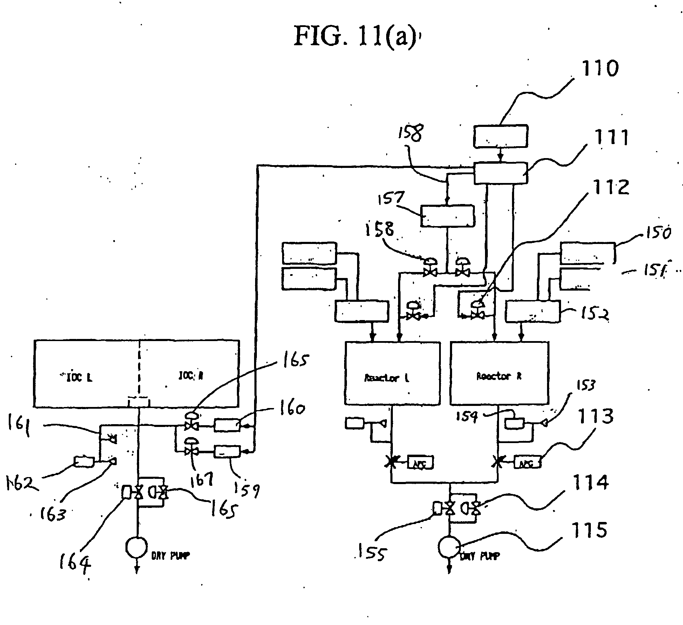

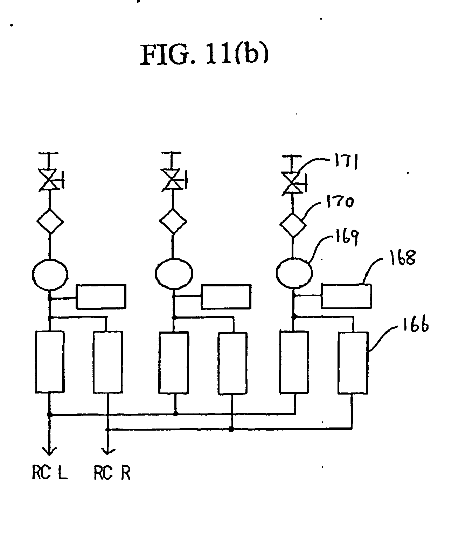

Another gas-line system according to the present invention is described in the following: FIG. 11(a) shows a gas-line system used for another embodiment. In this embodiment, because deposition can be performed simultaneously on two wafers, it is preferred to provide one gas line and one exhaust line for two reactors. A gas line for reactors comprises one line until it reaches a regulator box 110 and a gas box 111. A gas line branches off inside the gas box 111. A gas stop valve 112 is provided for each reactor. For an exhaust line, an APC (auto pressure controller) 113 and a vacuum gauge (not shown) are provided for each reactor and an exhaust valve 114 and a dry pump 115 are common to each reactor. FIG. 11(b) shows a gas supply system for Reactor L and Reactor R provided in the gas box 111. This figure shows three gas inlets, for example. Gas is supplied to each reactor via a manual stop valve 171, a gas filter 170, a pressure regulator 169, a pressure transducer 168, and an MFC (mass flow controller) 166.

In this embodiment, pressure is individually controlled by an APC 113 for each reactor and gas inside each reactor is discharged using a single pump (dry pump 115) provided with a fast pump valve 155 and a slow pump valve 114. A monometer 154 and a one-atom switch 153 is provided between the each reactor and the APC 113. Gas supply is controlled by an MFC for each reactor. A combination of the APC and the MFC independently can control deposition in the same manner as using one gas line per reactor. Additionally, because each reactor possesses a gas stop valve 112, processing can be performed using only one reactor, and labor reduction and lower costs can be achieved. Further, a gas (NF3, Art 158 is supplied from the gas box 111 to both Reactor L and Reactor R through an RGG (reactive gas generator) 157 and an RGG OUT valve 156. RF power is exerted on each reactor by mixing RF from a high radio frequency generator 150 and RF from a low radio frequency generator 151 using a matching box 152.

Additionally, FIG. 11 indicates a gas flow system in connection to a load lock chamber, which system is connected to the gas box 111. In the figure, "10C" (input-output chamber) is a load lock chamber. The gas flow system of the load lock chamber comprises similar elements to those used in the reactor. That is, gas is supplied from the gas box 111 to a flow meter 160 provided with a backfill valve 165 in parallel to a mass flow controller 159 provided with an N2 pump valve 167. The load lock chambers (IOC L and 1OC R) are evacuated using a dry pump through a slow pump valve 165 and a fast pump valve 164. In order to control gas flow, an over pressure switch 161, a crystal gauge 162, and a one atom switch 163 are provided in the gas flow system.

FIG. 7 shows a variation of the embodiment shown in FIG. 6. In the embodiment shown in FIG. 7, an electrical and gas line system comprises one RF generator, one gas line and two exhaust lines for two reactors. The gas-line system for two reactors shown in FIG. 7 comprises one gas line which includes a gas source 60, and gas stop valves 62 and 62' provided for each reactor respectively, and connected between the gas source 60 and each reactor (66 and 67), and two exhaust lines which include exhaust pumps 64 and 64', APCs 63 and 63' provided for each reactor respectively, and connected with the exhaust pumps 64 and 64' and vacuum exhaust valves 65 and 65' provided for each reactor respectively, and connected between the APC and each reactor. Switched by a switching means 71, an RF generator 70 is electrically alternately connected with each chamber (66 and 67).

The operation of the variation shown in FIG. 7 is described in the following: Vacuum exhaust valves 65 and 65' are opened and air inside the reactors 66 and 67 are evacuated by exhaust pumps 64 and 64'. First, the gas stop valve 62 for a reactor (for example, 66) to be used for deposition opens and a source gas is brought inside the reactor 66. High-frequency voltage is applied to a semiconductor substrate inside the reactor 66 by the RF generator 70 switched by the switching means 71 so as to be connected with the reactor 66, and a film-forming reaction occurs. An RGG OUT valve for a reactor (67, for example) to be cleaned opens, a cleaning gas is brought inside the reactor 67, and an etching reaction occurs inside the reactor 67. In the embodiment shown in FIG. 7, in this way, cleaning and deposition are performed in the respective reactors at the same time.

In the embodiment shown in FIG. 7, cleaning and deposition can be alternately performed by alternately bringing substrates into and out from two reactors by switching the RF generator 70 and the gas stop valves 62 and 62'. Additionally, since this system comprises one RF generator and one gas line for two reactors, labor reduction and lower costs can be achieved.

Lastly, a reactor unit according to the present invention is described in the following: FIG. 8 shows a preferred embodiment of a reactor unit according to the present invention. A reactor unit 80 for processing substrates sheet by sheet comprises a susceptor 81 for placing a semiconductor substrate 93 on, a seal plate 82 provided below the susceptor 81 and sharing the same shaft with the susceptor, elevating means 83, 84 and 85 for moving the susceptor 81 and the seal plate 82 in a vertical direction, a showerhead 92 for bringing in gas provided on the ceiling of the reactor 80, a duct means 86 with a seal surface 10 on its bottom surface, which is provided near the showerhead 92 and circularly along the surface of an internal wall of the reactor, a disk 89 provided between the susceptor 81 and the seal plate 82 and sharing the same shaft with the susceptor 81, a substrate lift pin 87 passing through the susceptor 81, which is supported by the disk 89, a floating elastic material 88 having one end engaged with the disk 89 and the other end attached to a concave portion provided on the seal plate 82, a susceptor shaft 95 for supporting the susceptor 81, which shaft 95 extends in a vertical direction, a cylindrical shaft 97 for supporting the seal plate 82, a susceptor interval-adjusting plate installed at the lower end of the susceptor shaft 95, a slide table 96 for transmitting thrust produced by elevating means 83, 84 and 85 to the cylindrical shaft 97, which is provided the lower end of the cylindrical shaft 97, and a pressing elastic material 94 for transmitting thrust produced by the elevating means to the slide table 96, which material 94 is provided between the slide table 96 and the elevating plate 84.

The radius of the seal plate 82 is larger than that of the susceptor 81 and its periphery protrudes upward. Preferably, an O-ring seal is provided on this protruding portion and the seal plate 82 is sealed up with a seal surface 107 at the bottom surface of the duct means 86. The concave portion on the surface of the seal plate 82 is provided to take in the floating elastic material 88 in a sealed position. For the floating elastic material 88, other elastic materials comprising preferably a spring can also be used, Alternatively, any number of floating elastic materials more than one can be used.

The disk 89 comprises a thin disk and its radius is larger than that of the susceptor 81 and smaller than that of the seal plate 82. In a sealed position, the disk 89 is held by the seal surface 107 of the duct means 86 and the seal plate 82 (See FIG. 10).

An elevating means comprises a ball screw 83, an elevating plate 84 and a driving means 85. The driving means 85 is preferably a pulse motor, but other means can also be used. Additionally, in addition to a combination of the ball screw 83 and the driving means 85, a pneumatic cylinder can also be used.

The susceptor shaft 95 passes through the inside of the cylindrical shaft 97. Near an opening at the top of the cylindrical shaft 97, an O-ring seal 90 is provided. The exterior of the cylindrical shaft 97 is covered by bellows 98. The bottom end of the susceptor shaft 95 is attached to the susceptor interval-adjusting plate 91. Intervals and levels between the showerhead 92 and the semiconductor substrate 93 can be adjusted independently of the seal plate 82.

The duct means 86 comprises a gas passage 100 for exhausting gas inside a processing chamber, which is described below, and an inactive (or inert) gas inlet port 101 for bringing in inactive gas to prevent a reaction gas from flowing in a lower portion from the susceptor surface during the deposition. The gas inside the processing chamber is exhausted from an exhaust port 99 provided on the side wall of the reactor after passing through the gas passage. Inactive gas (preferably, argon gas) is brought into the processing chamber from the inactive gas inlet port 101 and purges a reaction gas flowing into the lower portion from the susceptor surface.

At least three substrate lift pins 87 are provided for supporting the semiconductor substrate 93 on the susceptor 81. A step 102 is provided at the tip of the substrate lift pin 87. The circumference portion of the semiconductor 93 engages with the step 102 to support the semiconductor substrate 93 (See FIG. 10). Preferably, the width of the step 102 which the edge of the semiconductor substrate 93 contacts is less than 3mm.

The pressing elastic material 94 comprises preferably a conical spring, but other spring material can also be used.

As shown in FIG. 8, when the semiconductor substrate 93 is transferred, the floating elastic material 88 presses the disk 89 onto the bottom surface of the susceptor 81 by elasticity. In this structure, the substrate lift pin 87 protrudes from the susceptor surface and can receive the semiconductor substrate 93 with the step 102 at its tip. The step 102 not only functions as a guide when the semiconductor substrate is transferred, but also functions to prevent the substrate from sliding during the processing.

FIG. 9 shows a positional relation of each element when the semiconductor substrate is processed. FIG. 10 is an enlarged view of the area *a* in the FIG. 9. The ball screw 83 rotates by the driving means 85. At the same time, the elevating plate 84 rises and thrust is transmitted to the slide plate 96 through the pressing elastic material 94. As the slide plate 94 rises, the cylindrical shaft 97 and the susceptor shaft 95 rise and the bellows 98 contract.

The protruding periphery of the seal plate 82 shortly contacts the seal surface 10 on the bottom of the duct means 86 and forming a seal. In this structure, the interior of the reactor 80 is divided into a transfer chamber 104 and a processing chamber 103. When the seal plate is sealed, the periphery of the disk 89 is held by the bottom surface of the duct means 86 and a portion more inward than the protruding portion of the seal plate 82. This eliminates a gap between the disk 89 and the seal plate 82. At the same time, the floating elastic material 88 contracts and is taken completely into the concave portion provided on the surface of the seal plate 82.

In a sealed position, the tip of the substrate lift pin 87 descends to a position of the susceptor surface level or lower than the susceptor surface level. This places the semiconductor substrate 93 on the surface of the susceptor 81. A small reaction zone 105 is formed between the showerhead 92 and the semiconductor substrate 93. An interval between the showerhead 92 and the semiconductor substrate 93 is adjusted independently of the seal plate 82 by raising, lowering or tilting the susceptor interval-adjusting plate 91. The adjustment is done by rotating multiple adjusting screws 106 attached to the susceptor interval-adjusting plate 91.

With the elevating plate 84 further rising and the pressed elastic material 94 pressed by preferably 1mm to 3mm, the seal plate 82 is sealed more securely. The periphery of the seal plate 82 is pressed against the seal surface 107 of the duct means 86 by elasticity. This achieves appropriate sealing force. By observing how much the pressing elastic material 94 is displaced, whether secure seal is achieved or not can be confirmed.

After completion of final pressing of the seal plate 82, gas inside the processing chamber 103 is evacuated via a gas passage 100 of the duct means 86 through the exhaust port 99 to the outside. At the same time, argon gas is brought in from the inactive gas inlet port 101. A reaction gas is subsequently brought in from the showerhead 92 and processing begins.

A reactor unit according to the above embodiment of the present invention makes it possible to reduce the size of a reaction chamber and to shorten time for deposition and cleaning. Additionally, sealing of a through hole of the substrate lift pin is eliminated. Furthermore, the embodiment provides a simple seal structure, with which secure sealing can be achieved.

Another embodiment of a reactor unit according to the present invention is described. FIGs. 12(A) and (B) show another embodiment of a reactor unit according to the present invention.

A reactor unit in another embodiment comprises a susceptor 120 on which semiconductor substrates are placed, an elevating means 121 for moving the susceptor in a vertical direction, a showerhead 122 provided on the ceiling of the reactor for bringing in gas, a duct means 123 provided near the showerhead 122 and circularly along the surface of an internal wall of the reactor, and a circular baffle plate 124 sharing the same shaft with the duct means 123 and provided to create a slight gap 125 at the bottom surface of the duct means and a slight gap 126 along the periphery of the susceptor when a film is formed. A reaction gas is exhausted from the gap 125 formed between the baffle plate 124 and the duct means 123. An inactive gas (preferably, Ar or He) flows from the bottom to the top through the gap 126 formed between the baffle plate 124 and the susceptor 120. Purging by the inactive gas prevents a reaction gas or plasma (in the case of PE-CVD) from penetrating below the susceptor. The baffle plate 124 and the duct means 123 preferably comprise insulators, preventing unnecessary deposition.

Another embodiment can reduce the size of a reaction zone further as compared with the preferred embodiment.

Conventional techniques similar to the present invention are now described and differences between them are examined. First, differences between Japanese Patent Laid-open No.10-30183 ("Conventional Technique 1") and the present invention are discussed. In the Conventional Technique 1, an ashing apparatus similar to the present invention is mentioned. A transfer mechanism inside a load lock chamber is characterized in that a hand unit holding a semiconductor substrate is taken into and out from a processing chamber by rotating or moving an arm in a straight line.

In an embodiment mentioned in the Conventional Technique 1 for rotating the arm, a semiconductor substrate is transferred into a processing chamber by drawing an arc around the rotating shaft of the arm. In contrast, in the semiconductor-manufacturing apparatus according to the present invention, a semiconductor substrate is transferred in a straight line.

Additionally, in an embodiment mentioned in the Conventional Technique 1 for moving the arm in a straight line, a semiconductor substrate is transferred by a slide shaft. In contrast, in the substrate transfer mechanism according to the present invention, a semiconductor substrate is transferred by an arm shaft.

Furthermore, a reactor unit in the Conventional Technique 1 is not configured as a cluster. In contrast, in the semiconductor-manufacturing apparatus according to the present invention, a reactor unit is modularized and can be configured as a cluster. One of the characteristics of the present invention is that modularized reactor units can be configured as a cluster through AFEs.

As described above, it can be seen that the apparatus space and dead space are larger in the Conventional Technique 1 as compared with the present invention. According to the present invention, a small capacity of less than 10L can be realized for a load lock chamber accommodating a substrate with a diameter of 300mm.

Secondly, differences between Japanese Patent Laid-open No.10.154739 ("Conventional Technique 2") and the present invention are discussed. In the Conventional Technique 2, disclosed is a substrate-processing apparatus comprising (a) a load lock chamber, (b) a transfer chamber, (c) more than one reactors, each being connected to the transfer chamber and having multiple (virtually two) processing zones, and (d) a first substrate-handling member provided inside the transfer chamber. The first substrate-handling member possesses multiple substrate-handling blades virtually on the same plane, which simultaneously transfer multiple (virtually two) semiconductor substrates between a load lock chamber and more than one reactors, and which simultaneously moves semiconductor substrates to separate reactors. A reaction gas is distributed from more than one gas source to each processing zone (virtually two) inside the reactor. Gas in each processing zone (virtually two) is discharged outside the reactor using a single pump.

First, the substrate-processing apparatus mentioned in the Conventional Technique 2 possesses a transfer chamber and a substrate-handlihg member provided inside the transfer chamber. In contrast, the semiconductor-manufacturing apparatus according to the present invention does not possess a transfer chamber, and the load lock chamber is directly connected with the reactor.

Secondly, the substrate-processing apparatus mentioned in the Conventional Technique 2 possesses multiple substrate-handling blades provided virtually on the same plane inside the same chamber. In contrast, the semiconductor-manufacturing apparatus according to the present invention possesses a substrate transfer mechanism independently provided inside each load lock chamber.

Thirdly, in the substrate-processing apparatus mentioned in the Conventional Technique 2, a unit comprising a reactor and a load lock chamber is not modularized. In contrast, in the semiconductor-manufacturing apparatus according to the present invention, a unit comprising a reactor and a load lock chamber is modularized so that at least two units are adjacently connected.

Fourthly, in the substrate-processing apparatus mentioned in the Conventional Technique 2, a gas flow is divided simply by a T-shaped joint. In contrast, in the semiconductor-manufacturing apparatus according to the present invention, a flow divider, which has capability to distribute a gas flow of 0 to 10SLM inputted on the primary side in equal amounts to the secondary side, is used for dividing a gas flow. Additionally, the substrate-processing apparatus mentioned in the Conventional Technique 2 possesses two processing zones inside one reactor, and gas is discharged using a single pump after combining exhaust ports of the processing zones inside the reactor. In contrast, in the semiconductor-manufacturing apparatus according to the present invention, each processing zone inside the reactor is independent and gas inside each reactor is discharged using a single pump by controlling pressure for each reactor using an APC, etc.

By using this independent pressure control and the above-mentioned flow divider with which a gas flow is divided equally, deposition can be independently controlled in the same manner as in the case where a gas line for each reactor is used. Furthermore, the semiconductor-manufacturing apparatus according to the present invention possesses a gas stop valve and a vacuum exhaust valve for each reactor. Even though the configuration is one gas line for two reactors, processing can be performed using one reactor only.

As discussed above, the semiconductor-manufacturing apparatus mentioned in the Conventional Techniques 1 and 2 and the semiconductor-manufacturing apparatus according to the present invention differ in their apparatus configurations and effects.

## Claims

1. A semiconductor processing module adapted to be connected to an atmospheric robot unit, comprising;
(a) multiple single-wafer processing units disposed side by side, each unit comprising:
a reactor (1) for treating a semiconductor substrate (20), said reactor having a pressure control valve in a gas exhaust line; and
at least one load lock chamber (3) for transferring the semiconductor substrate into and from the reactor in a vacuum, said load lock chamber having a front end and a rear end, said rear end being connected immediately to said reactor via a gate valve (2), said front end being adapted to be connected to the atmospheric robot unit (5) via a flapper valve (21), said load lock chamber comprising a vacuum robot (4) having linked arms with one revolving shaft for transferring the semiconductor substrate into and from said reactor by straight movement through the gate valve; and
(b) a gas supply system common to said multiple units, wherein gas flow of each reactor is controlled by the pressure control valve provided in each reactor.

2. The semiconductor processing module according to Claim 1, wherein the pressure control valve is an auto pressure control (APC) butterfly valve (63, 63').

3. The semiconductor processing module according to Claim 1, wherein said load lock chambers (131, 132) communicate with each other through a manifold (135) connecting a lower portion of each load lock chamber, whereby vacuum operation is controlled as one load lock chamber.

4. The semiconductor processing module according to Claim 1, which is composed of two single-wafer processing units (30, 36).

5. The semiconductor processing module according to Claim 1, wherein each unit has two load lock chambers (30, 36), one chamber being placed on top of the other chamber, one of said chambers transferring the semiconductor substrate into the reactor in a vacuum, the other chamber transferring the semiconductor substrate from the reactor in a vacuum.

6. The semiconductor processing module according to Claim 1, wherein the gas supply system (60) is provided with a flow divider (61) for supplying gas equally to each reactor (66, 67).

7. The semiconductor processing module according to Claim 6, further comprising a gas stop valve (62, 62') for each reactor between said flow divider and each reactor (66, 67).

8. The semiconductor processing module according to Claim 1, further comprising a vacuum exhaust valve (65, 65') for each reactor between the pressure control valve and the reactor.

9. The semiconductor processing module according to Claim 1, wherein the gas supply system is provided with a mass flow controller (166) for each reactor.

10. The semiconductor processing module according to Claim 1, wherein the gas exhaust system is common to the respective reactors.

11. The semiconductor processing module according to Claim 1, further comprising one RF generator (150) and a switch for electrically connecting said RF generator and one of the reactors, wherein deposition and cleaning are alternately performed in the respective reactors.

12. The semiconductor processing module according to Claim 1, wherein the reactor (80) comprises:
a susceptor (81) for placing a semiconductor substrate (93) thereon;
a seal plate (82) provided below and coaxially with said susceptor, said seal plate having a larger diameter than the susceptor and a seal surface along its periphery;
an elevating/descending device (83, 84, 85) for moving said susceptor and said seal in a vertical direction;
a showerhead (92) provided on a ceiling of said reactor for introducing gas; and
a duct member (86) provided near said showerhead and having a circular projection formed along an inner wall of said reactor, wherein:
(a) at a position where the susceptor and the seal plate elevate and the seal surface of the seal plate contacts the circular projection of the duct member, the interior of the reactor is divided by the seal plate into an upper reaction compartment and a lower compartment, in which reaction compartment a substrate on the susceptor is treated; and
(b) at a position where the susceptor and the seal plate descend, a substrate is transferred via the gate valve.

13. The semiconductor processing module according to Claim 12, wherein the reactor further comprises:
at least three substrate lift pins (87) passing through said susceptor for supporting a substrate over said susceptor (81);
a disk (89) for supporting said substrate lift pins, which is provided between the susceptor and the seal plate and coaxially with said susceptor, said disk having a diameter smaller than the seal plate but larger than the inner diameter of the circular projection; and
a floating elastic material (88) having an upper end supporting said disk from its back and a lower end inserted in a recess formed in said seal plate (82),
wherein when said seal plate is sealed to said circular projection of the duct member, said disk is also held by the circular projection to push said floating elastic material back in the recess of the seal plate, and said substrate lift pins descend to a position where the tip of each substrate lift pin is at a level the same as or lower than a susceptor surface.

14. The semiconductor processing module according to Claim 13, wherein the seal plate is provided with a pressing elastic material (94) for securing the seal between the seal surface of the seal plate and the circular projection.

15. The semiconductor processing module according to Claim 12, further comprising a susceptor height adjusting plate for adjusting the distance between the susceptor and the seal plate, thereby adjusting the distance between the showerhead and the susceptor when the susceptor and the seal plate elevate and the seal plate seals the circular projection of the duct, said susceptor height adjusting plate being installed along and coaxially with a susceptor shaft.

16. The semiconductor processing module according to Claim 1, wherein the reactor comprises:
a susceptor for placing a semiconductor substrate thereon;
an elevating/descending device for moving said susceptor in a vertical direction;
a showerhead provided on a ceiling of said reactor for introducing gas;
a duct member provided near said showerhead and formed along an inner wall of said reactor; and
a circular baffle plate (124) provided on the inner wall of said reactor immediately below the duct member, wherein a gap is formed between the circular baffle plate and the duct member, said circular baffle plate having an inner diameter slightly smaller than the susceptor, wherein:
(a) at a position where the susceptor elevates and is leveled with the circular baffle plate, the interior of the reactor is divided into an upper reaction compartment and a lower compartment, in which reaction compartment a substrate on the susceptor is treated, wherein an exhaust gas is discharged from the upper reaction compartment through the gap formed between the circular baffle plate and the duct member, and a shield gas is provided into the reaction compartment from the lower compartment through a gap formed between the susceptor and the circular baffle plate; and
(b) at a position where the susceptor descends, a substrate is transferred via the gate valve.

17. The semiconductor processing module according to Claim 16, wherein said duct member (123) and said baffle plate (124) are made of an insulation material.

18. A semiconductor processing apparatus comprising at least one module of Claim 1 and an atmospheric robot unit (51) including an atmospheric robot (53) for transferring a substrate into and from each reactor.

19. The semiconductor processing apparatus according to Claim 18, wherein the atmospheric robot unit has a sliding shaft in parallel to the load lock chambers, on which shaft the atmospheric robot slides to position in front of each load lock chamber.

20. The semiconductor processing apparatus according to Claim 18, wherein multiple modules are aligned side by side in a line.

21. The semiconductor processing apparatus according to Claim 20, wherein the multiple modules are disposed facing each other via a common atmospheric robot unit comprising an atmospheric robot for transferring a substrate into and from each load lock chamber.

22. The semiconductor processing apparatus according to Claim 21, further comprising an atmospheric transport unit which is connected to the atmospheric robot unit and a loading port, wherein the atmospheric transport unit transfers a substrate or substrates between the atmospheric robot and the loading port.

23. The semiconductor processing apparatus according to Claim 22, which includes the loading port comprising a cassette and/or an inspection unit.

24. The semiconductor processing apparatus according to Claim 22, wherein the atmospheric transport unit comprises:
a slot and an arm shaft for collectively transferring multiple substrates; an elevating/descending shaft; and
a rotating shaft for transferring substrates between the loading port and the atmospheric robot,
wherein said atmospheric transport unit collectively moves multiple substrates to a position where a substrate is transferred between the atmospheric transport unit and the atmospheric robot while the atmospheric robot does not slide on the sliding shaft.

## Patentansprüche

1. Halbleiterverarbeitungsmodul mit geeigneter Ausgestaltung, um an eine Luftrobotereinheit angeschlossen zu werden, mit:
(a) mehreren Einzelwafer-Verarbeitungseinheiten, die nebeneinander angeordnet sind, wobei jede Einheit aufweist:
einen Reaktor (1) für die Behandlung eines Halbleitersubstrats (20), der in einer Abgasleitung ein Drucksteuerventil hat; und
mindestens eine Chargenschleusenkammer (3) für das Überführen des Halbleitersubstrats in den Reaktor und aus diesem heraus in einem Vakuum, wobei die Chargenschleusenkammer ein Vorderende und ein Hinterende hat, das Hinterende unmittelbar mit dem Reaktor über ein Absperrventil (2) verbunden ist, das Vorderende geeignet ausgestaltet ist, um über ein Prallplattenventil (21) mit der Luftrobotereinheit (5) verbunden zu werden, wobei die Chargenschleusenkammer einen Vakuumroboter (4) aufweist mit angelenkten Armen mit einem Drehschaft zum Überführen des Halbleitersubstrats in den Reaktor und aus diesem heraus durch eine gerade Bewegung durch das Absperrventil; und
(b) einem Gaszuführsystem, welches den mehreren Einheiten gemeinsam ist, wobei der Gasfluß jedes Reaktors von dem in jedem Reaktor vorgesehenen Drucksteuerventil gesteuert wird.

2. Halbleiterverarbeitungsmodul nach Anspruch 1, wobei das Drucksteuerventil ein Drosselventil (63, 63') mit Selbstdrucksteuerung (APC) ist.

3. Halbleiterverarbeitungsmodul nach Anspruch 1, wobei die Chargenschleusenkammern (131, 132) über einen Verteiler (135) miteinander verbunden sind, der sich an einen unteren Abschnitt jeder Chargenschleusenkammer anschließt, wodurch ein Vakuumbetrieb wie eine Chargenschleusenkammer gesteuert wird.

4. Halbleiterverarbeitungsmodul nach Anspruch 1, der aus zwei Einzelwafer-Verarbeitungseinheiten (30, 36) besteht.

5. Halbleiterverarbeitungsmodul nach Anspruch 1, wobei jede Einheit zwei Chargenschleusenkammern (30, 36) hat, deren eine Kammer oben auf der anderen Kammer angeordnet ist, eine der Kammern das Halbleitersubstrat in einem Vakuum in den Reaktor überführt und die andere Kammer das Halbleitersubstrat in einem Vakuum aus dem Reaktor herausführt.

6. Halbleiterverarbeitungsmodul nach Anspruch 1, wobei das Gaszuführsystem (60) mit einem Flußteiler (81) versehen ist, um Gas in gleichem Maß jedem Reaktor (66, 67) zuzuführen.

7. Halbleiterverarbeitungsmodul nach Anspruch 6, ferner mit einem Gasrückschlagventil (62, 62') für jeden Reaktor zwischen dem Flußteiler und jedem Reaktor (66, 67).

8. Halbleiterverarbeitungsmodul nach Anspruch 1, ferner mit einem Vakuumauslaßventil (65, 65') für jeden Reaktor zwischen dem Drucksteuerventil und dem Reaktor.

9. Halbleiterverarbeitungsmodul nach Anspruch 1, wobei das Gaszuführsystem für jeden Reaktor mit einer Massenflußsteuereinrichtung (166) versehen ist.

10. Halbleiterverarbeitungsmodul nach Anspruch 1, wobei das Gasauslaßventil den entsprechenden Reaktoren gemeinsam ist.

11. Halbleiterverarbeitungsmodul nach Anspruch 1, ferner mit einem Hochfrequenzgenerator (150) und einem Schalter für das elektrische Verbinden des Hochfrequenzgenerators und einem der Reaktoren, wobei die Ablagerung bzw. Abscheidung und das Reinigen abwechselnd in den entsprechenden Reaktoren durchgeführt werden.

12. Halbleiterverarbeitungsmodul nach Anspruch 1, wobei der Reaktor (80) aufweist:
einen Suszeptor (81), um ein Halbleitersubstrat (93) auf diesem anzuordnen;
eine Dichtplatte (82), die unter dem Suszeptor und koaxial zu diesem vorgesehen ist und einen größeren Durchmesser hat als der Suszeptor sowie eine Abdichtfläche längs ihres Umfanges hat;
eine Anhebe-/Absenkvorrichtung (83, 84, 85) zum Bewegen des Suszeptors und der Dichtung in einer vertikalen Richtung;
einen an einer Oberwand des Reaktors vorgesehenen Duschkopf (92) zum Einführen von Gas; und
ein Rohrleitungsteil (86), welches nahe dem Duschkopf vorgesehen ist und einen kreisförmigen Vorsprung hat, der längs einer Innenwand des Reaktors gebildet ist, wobei:
(a) an einer Position, an welcher der Suszeptor und die Abdichtplatte sich erheben und die Abdichtoberfläche der Dichtplatte mit dem kreisförmigen Vorsprung des Rohrleitungsteils in Berührung kommt, das Innere des Reaktors durch die Abdichtplatte in eine obere Reaktionskammer und eine untere Reaktionskammer aufgeteilt wird, wobei in der Reaktionskammer ein Substrat auf dem Suszeptor behandelt wird; und
(b) an einer Position, in welcher der Suszeptor und die Abdichtplatte sich absenken, ein Substrat über das Absperrventil überführt wird.

13. Halbleiterverarbeitungsmodul nach Anspruch 12, wobei der Reaktor ferner aufweist:
mindestens drei Substratanhebestifte (87), welche durch den Suszeptor für die Halterung eines Substrats über dem Suszeptor (81) hindurchgehen;
eine Scheibe (89) zum Abstützen der Substratanhebestifte, wobei die Scheibe (89) zwischen dem Suszeptor und der Abdichtplatte und koaxial zu dem Suszeptor vorgesehen ist und einen Durchmesser hat, der kleiner ist als die Abdichtplatte, aber größer als der Innendurchmesser des kreisförmigen Vorsprungs; und
ein schwimmendes elastisches Material (88) mit einem oberen Ende, welches die Scheibe von ihrer Rückseite und einem unteren Ende haltert, das in einer in der Abdichtplatte (82) gebildeten Ausnehmung eingefügt ist,
wobei, wenn die Abdichtplatte gegen den kreisförmigen Vorsprung des Rohrleitungsteils abgedichtet ist, die Scheibe auch von dem kreisförmigen Vorsprung gehalten wird, um das schwimmende elastische Material in die Ausnehmung der Abdichtplatte zurückzustoßen, und die Substratanhebestifte auf eine Position absinken, in welcher sich die Spitze jedes Substratanhebestifts auf derselben oder einer niedrigeren Höhe als eine Suszeptoroberfläche befindet.

14. Halbleiterverarbeitungsmodul nach Anspruch 13, wobei die Abdichtplatte mit einem elastischen Druckmaterial (94) versehen ist für das Sichern der Dichtung zwischen der Abdichtoberfläche der Abdichtplatte und dem kreisförmigen Vorsprung.

15. Halbleiterverarbeitungsmodul nach Anspruch 12, ferner mit einer die Suszeptorhöhe einstellenden Platte zum Einstellen des Abstandes zwischen dem Suszeptor und der Abdichtplatte, wodurch der Abstand zwischen dem Duschkopf und dem Suszeptor eingestellt wird, wenn sich der Suszeptor und die Abdichtplatte anheben und die Abdichtplatte den kreisförmigen Vorsprung der Rohrleitung abdichtet, wobei die die Suszeptorhöhe einstellende Platte längs eines Suszeptorschaftes und koaxial zu dieser installiert wird.

16. Halbleiterverarbeitungsmodul nach Anspruch 1, wobei der Reaktor aufweist:
einen Suszeptor, um ein Halbleitersubstrat auf diesem anzuordnen;
eine Anhebe/Absenkvorrichtung für das Bewegen des Suszeptors in einer vertikalen Richtung;
einen Duschkopf, der an einer Oberwand des Reaktors zum Einführen von Gas vorgesehen ist;
ein Rohrleitungsteil, welches nahe dem Duschkopf vorgesehen und längs einer inneren Wand des Reaktors gebildet ist; und
eine kreisförmige Stauplatte (124), die an der Innenwand des Reaktors unmittelbar unter dem Rohrleitungsteil vorgesehen ist, wobei ein Spalt zwischen der kreisförmigen Stauplatte und dem Rohrleitungsteil gebildet ist und die kreisförmige Stauplatte einen Innendurchmesser hat, der etwas kleiner ist als der Suszeptor, wobei:
(a) in einer Position, in welcher sich der Suszeptor anhebt und mit der kreisförmigen Stauplatte bündig gemacht ist, das Innere des Reaktors in ein oberes Reaktionsabteil und ein unteres Reaktionsabteil geteilt wird, in dem Reaktionsabteil ein Substrat auf dem Suszeptor behandelt wird, ein Abgas aus dem oberen Reaktionsabteil durch den Spalt abgeführt wird, der zwischen der kreisförmigen Stauplatte und dem Rohrleitungsteil gebildet ist, und ein Schutzgas in das Reaktionsabteil hinein aus dem unteren Abteil durch einen Spalt vorgesehen wird, welcher zwischen dem Suszeptor und der kreisförmigen Stauplatte gebildet ist; und
(b) an einer Position, bei welcher der Suszeptor absinkt, ein Substrat über das Absperrventil überführt wird.

17. Halbleiterverarbeitungsmodul nach Anspruch 16, wobei das Rohrleitungsteil (123) und die Stauplatte (124) aus einem Isolationsmaterial hergestellt sind.

18. Halbleiterverarbeitungsvorrichtung mit mindestens einem Modul nach Anspruch 1 und einer Luftrobotereinheit (51), die einen Luftroboter (53) für das Überführen eines Substrats in jeden Reaktor hinein und aus diesem heraus aufweist.

19. Halbleiterverarbeitungsvorrichtung nach Anspruch 18, wobei die Luftrobotereinheit einen Gleitschaft parallel zu den Chargenschleusenkammern hat und auf dem Schaft der Luftroboter gleitet, um sich vor jede Chargenschleusenkammer zu positionieren.

20. Halbleiterverarbeitungsvorrichtung nach Anspruch 18, wobei mehrere Module nebeneinander in einer Linie ausgerichtet sind.

21. Halbleiterverarbeitungsvorrichtung nach Anspruch 20, wobei die mehreren Module so angeordnet sind, daß sie über eine gemeinsame Luftrobotereinheit einander zu gerichtet sind, welche einen Luftroboter aufweist für das Überführen eines Substrats in jede Chargenschleusenkammer und aus dieser heraus.

22. Halbleiterverarbeitungsvorrichtung nach Anspruch 21, ferner mit einer Lufttransporteinheit, die mit der Luftrobotereinheit und einem Beladeanschluß verbunden ist, wobei die Lufttransporteinheit ein Substrat oder Substrate zwischen dem Luftroboter und dem Beladeanschluß überführt.

23. Halbleiterverarbeitungsvorrichtung nach Anspruch 22, die einen Beladeanschluß mit einer Kassette und/oder einer Inspektionseinheit aufweist.

24. Halbleiterverarbeitungsvorrichtung nach Anspruch 22, wobei die Lufttransporteinheit aufweist:
einen Schlitz und einen Armschaft für das gemeinsame Überführen mehrerer Substrate;
einen Anhebe-/Absenkschaft; und
einen Drehschaft für das Überführen von Substraten zwischen dem Beladeanschluß und dem Luftroboter,
wobei die Lufttransporteinheit gemeinsam mehrere Substrate in eine Position bewegt, in welcher ein Substrat zwischen der Lufttransporteinheit und dem Luftroboter überführt wird, während der Luftroboter nicht auf dem Gleitschaft gleitet.

## Revendications

1. Module de traitement de semi-conducteurs conçu pour être connecté à une unité à robot atmosphérique, comportant :
(a) de multiples unités de traitement de tranches individuelles disposées côte à côte, chaque unité comportant :
un réacteur (1) pour le traitement d'un substrat semi-conducteur (20), ledit réacteur ayant un robinet de réglage de pression dans une conduite d'évacuation de gaz ; et
au moins une chambre (3) de sas de chargement pour transférer le substrat semi-conducteur sous vide dans le réacteur et à partir de celui-ci, ladite chambre de sas de chargement ayant une extrémité avant et une extrémité arrière, ladite extrémité arrière étant raccordée immédiatement audit réacteur par l'intermédiaire d'une vanne à passage direct (2), ladite extrémité avant étant conçue pour être raccordée à l'unité à robot atmosphérique (5) par l'intermédiaire d'une vanne à clapet (21), ladite chambre de sas de chargement comportant un robot (4) à vide ayant des bras articulés avec un arbre de révolution pour le transfert du substrat semi-conducteur dans ledit réacteur et à partir de celui-ci par un mouvement direct à travers la vanne à passage direct ; et
(b) un système d'alimentation en gaz commun auxdites unités multiples, dans lequel un écoulement de gaz de chaque réacteur est commandé par le robinet de commande de pression prévu dans chaque réacteur.

2. Module de traitement de semi-conducteurs selon la revendication 1, dans lequel le robinet de commande de pression est un robinet à papillon (63, 63') de commande automatique de pression (APC).

3. Module de traitement de semi-conducteurs selon la revendication 1, dans lequel lesdites chambres (131, 132) de sas de chargement communiquent entre elles à travers un collecteur (135) se raccordant à une partie inférieure de chaque chambre de sas de chargement, grâce à quoi une opération sous vide est commandée concernant une seule chambre de sas de chargement.

4. Module de traitement de semi-conducteurs selon la revendication 1, qui est composé de deux unités (30, 36) de traitement de tranches individuelles.

5. Module de traitement de semi-conducteurs selon la revendication 1, dans lequel chaque unité comporte deux chambres (30, 36) de sas de chargement, une chambre étant placée sur le dessus de l'autre chambre, l'une desdites chambres transférant le substrat semi-conducteur dans le réacteur sous vide, l'autre chambre transférant le substrat semi-conducteur depuis le réacteur sous vide.

6. Module de traitement de semi-conducteurs selon la revendication 1, dans lequel le système (60) d'alimentation en gaz est pourvu d'un diviseur (61) d'écoulement pour alimenter en gaz de façon égale chaque réacteur (66, 67).

7. Module de traitement de semi-conducteurs selon la revendication 6, comportant en outre un robinet (62, 62') d'arrêt de gaz pour chaque réacteur entre ledit diviseur d'écoulement et chaque réacteur (66, 67).

8. Module de traitement de semi-conducteurs selon la revendication 1, comportant en outre un robinet (65, 65') d'évacuation pour le vide pour chaque réacteur entre le robinet de commande de pression et le réacteur.

9. Module de traitement de semi-conducteurs selon la revendication 1, dans lequel le système d'alimentation en gaz est pourvu d'un régulateur (166) d'écoulement massique pour chaque réacteur.

10. Module de traitement de semi-conducteurs selon la revendication 1, dans lequel le système d'évacuation de gaz est commun aux réacteurs respectifs.

11. Module de traitement de semi-conducteurs selon la revendication 1, comportant en outre un générateur RF (150) et un commutateur pour connecter électriquement ledit générateur RF et l'un des réacteurs, dans lequel un dépôt et un nettoyage sont exécutés de façon alternée dans les réacteurs respectifs.

12. Module de traitement de semi-conducteurs selon la revendication 1, dans lequel le réacteur (80) comporte :
un suscepteur (81) sur lequel un substrat semi-conducteur (93) est destiné à être placé ;
une plaque de joint d'étanchéité (82) placée en dessous dudit suscepteur et coaxialement à celui-ci, ladite plaque de joint d'étanchéité ayant un plus grand diamètre que le suscepteur et une surface d'étanchéité le long de sa périphérie ;
un dispositif d'élévation/de descente (83, 84, 85) destiné à déplacer ledit suscepteur et ledit joint d'étanchéité dans une direction verticale ;
une tête d'aspersion (92) située au plafond dudit réacteur pour l'introduction d'un gaz ; et
un élément de conduit (86) prévu à proximité de ladite tête d'aspersion et ayant une saillie circulaire formée le long d'une paroi intérieure dudit réacteur, dans lequel :
(a) dans une position où le suscepteur et la plaque de joint d'étanchéité s'élèvent et la surface d'étanchéité de la plaque de joint d'étanchéité est en contact avec la saillie circulaire de l'élément de conduit, l'intérieur du réacteur est divisé par la plaque de joint d'étanchéité en un compartiment supérieur de réaction et un compartiment inférieur, compartiment de réaction dans lequel un substrat se trouvant sur le suscepteur est traité ; et
(b) dans une position où le suscepteur et la plaque de joint d'étanchéité descendent, un substrat est transféré en passant par la vanne à passage direct.

13. Module de traitement de semi-conducteurs selon la revendication 12, dans lequel le réacteur comporte en outre :
au moins trois broches (87) de soulèvement de substrat passant à travers ledit suscepteur pour supporter un substrat au-dessus dudit suscepteur (81) ;
un disque (89) destiné à supporter lesdites broches de soulèvement de substrat, qui est placé entre le suscepteur et la plaque de joint d'étanchéité et qui est coaxial audit suscepteur, ledit disque ayant un diamètre plus petit que celui de la plaque de joint d'étanchéité, mais plus grand que le diamètre intérieur de la saillie circulaire ; et
une matière élastique flottante (88) ayant une extrémité supérieure supportant ledit disque par son côté arrière et une extrémité inférieure insérée dans un évidement formé dans ladite plaque de joint d'étanchéité (82),
dans lequel, lorsque ladite plaque de joint d'étanchéité est appliquée de façon étanche sur ladite saillie circulaire de l'élément de conduit, ledit disque est également maintenu par la saillie circulaire afin de repousser ladite matière élastique flottante en arrière dans l'évidement de la plaque de joint d'étanchéité, et lesdites broches de soulèvement du substrat descendent jusqu'à une position où l'extrémité de chaque broche de soulèvement du substrat est au même niveau ou plus basse qu'une surface du suscepteur.

14. Module de traitement de semi-conducteurs selon la revendication 13, dans lequel la plaque de joint d'étanchéité est pourvue d'une matière élastique (94) d'application de pression pour assurer l'étanchéité entre la surface d'étanchéité de la plaque de joint d'étanchéité et la saillie circulaire.

15. Module de traitement de semi-conducteurs selon la revendication 12, comportant en outre une plaque de réglage de la hauteur du suscepteur pour régler la distance entre le suscepteur et la plaque de joint d'étanchéité, réglant ainsi la distance entre la tête d'aspersion et le suscepteur lorsque le suscepteur et la plaque de joint d'étanchéité s'élèvent et que la plaque d'étanchéité s'applique de façon étanche contre la saillie circulaire du conduit, ladite plaque de réglage de la hauteur du suscepteur étant installée le long d'une tige du suscepteur et étant coaxiale à cette tige.

16. Module de traitement de semi-conducteurs selon la revendication 1, dans lequel le réacteur comporte :
un suscepteur sur lequel un substrat semi-conducteur est destiné à être placé ;
un dispositif d'élévation/de descente pour déplacer ledit suscepteur dans une direction verticale ;
une tête d'aspersion située sur un plafond dudit réacteur pour l'introduction d'un gaz ;
un élément de conduit prévu à proximité de ladite tête d'aspersion et formé le long d'une paroi intérieure dudit réacteur ; et
une plaque circulaire (124) de déflecteur située sur la paroi intérieure dudit réacteur immédiatement en dessous de l'élément de conduit, un espace étant formé entre la plaque circulaire de déflecteur et l'élément de conduit, ladite plaque circulaire de déflecteur ayant un diamètre intérieur légèrement inférieur à celui du suscepteur, dans lequel :
(a) dans une position où le suscepteur s'élève et est au même niveau que la plaque circulaire de déflecteur, l'intérieur du réacteur est divisé en un compartiment supérieur de réaction et un compartiment inférieur, compartiment de réaction dans lequel un substrat se trouvant sur le suscepteur est traité, un gaz d'évacuation étant déchargé du compartiment supérieur de réaction à travers l'espace formé entre la plaque circulaire de déflecteur et l'élément de conduit, et un gaz formant écran étant introduit dans le compartiment de réaction depuis le compartiment inférieur à travers un espace formé entre le suscepteur et la plaque circulaire de déflecteur ; et
(b) dans une position où le suscepteur descend, un substrat est transféré en passant par la vanne à passage direct.

17. Module de traitement de semi-conducteurs selon la revendication 16, dans lequel ledit élément de conduit (123) et ladite plaque de déflecteur (124) sont formées d'une matière isolante.

18. Appareil de traitement de semi-conducteurs comportant au moins un module selon la revendication 1 et une unité à robot atmosphérique (51) comprenant un robot atmosphérique (53) pour transférer un substrat dans chaque réacteur et à partir de celui-ci.

19. Appareil de traitement de semi-conducteurs selon la revendication 18, dans lequel l'unité à robot atmosphérique comporte une barre coulissante en parallèle avec les chambres de sas de chargement, barre sur laquelle le robot atmosphérique coulisse jusqu'à une position située en face de chaque chambre de sas de chargement.

20. Appareil de traitement de semi-conducteurs selon la revendication 18, dans lequel des modules multiples sont alignés côte à côte suivant une ligne.

21. Appareil de traitement de semi-conducteurs selon la revendication 20, dans lequel les modules multiples sont disposés face à face par l'intermédiaire d'une unité commune à robot atmosphérique comportant un robot atmosphérique pour transférer un substrat dans chaque chambre de sas de chargement et à partir de cette chambre.

22. Appareil de traitement de semi-conducteurs selon la revendication 21, comportant en outre une unité de transport atmosphérique qui est raccordée à l'unité à robot atmosphérique et à une ouverture de chargement, l'unité de transport atmosphérique transférant un substrat ou des substrats entre le robot atmosphérique et l'ouverture de chargement.

23. Appareil de traitement de semi-conducteurs selon la revendication 22, qui comprend l'ouverture de chargement comportant une cassette et/ou une unité d'inspection.

24. Appareil de traitement de semi-conducteurs selon la revendication 22, dans lequel l'unité de transport atmosphérique comporte :
une fente et un arbre de bras pour transférer collectivement des substrats multiples ;
un arbre montant/descendant ; et
un arbre tournant pour transférer des substrats entre l'ouverture de chargement et le robot atmosphérique,
dans lequel ladite unité de transport atmosphérique déplace ensemble des substrats multiples jusqu'à une position où un substrat est transféré entre l'unité de transport atmosphérique et le robot atmosphérique tandis que le robot atmosphérique ne coulisse pas sur la barre de coulissement.
